# EUROPÄISCHE PATENTSCHRIFT

(11) **EP 4 337 970 B1**
(45) Veröffentlichungstag und Bekanntmachung des Hinweises auf die Patenterteilung: **04.03.2026**
(21) Anmeldenummer: 22723544.7
(22) Anmeldetag: 19.04.2022
(51) Int. Cl.: G01R 31/34

(54) **VERFAHREN ZUR PRÜFUNG EINES DREHSTROMMOTORS UND PRÜFANORDNUNG FÜR EINEN DREHSTROMMOTOR**
METHOD FOR TESTING A THREE-PHASE MOTOR AND TEST ARRANGEMENT FOR A THREE-PHASE MOTOR
PROCÉDÉ DE TEST D'UN MOTEUR TRIPHASÉ ET DISPOSITIF DE TEST D'UN MOTEUR TRIPHASÉ

(30) Priorität: 12.05.2021 DE 102021002504
(43) Veröffentlichungstag der Anmeldung: 20.03.2024
(73) Patentinhaber: SEW-EURODRIVE GmbH & Co. KG, 76646 Bruchsal (DE)
(72) Erfinder: EDIGHOFFER, Christophe, 67360 Goersdorf (FR)
(86) Internationale Anmeldenummer: PCT/EP2022/025154
(87) Internationale Veröffentlichungsnummer: WO 2022/237998

(56) Entgegenhaltungen:
- DE-A1- 102016 222 015
- DE-A1- 102019 008 365

## Beschreibung

Die Erfindung betrifft ein Verfahren zur Prüfung eines Drehstrommotors und eine Prüfanordnung für einen Drehstrommotor.

Es ist allgemein bekannt, dass nach Herstellung eines Produkts dieses zur Sicherung der Qualität geprüft werden kann.

Aus der US 4 651 086 A ist ein Verfahren zur Spulenwiderstandsbestimmung bekannt.

Aus der DE 10 2014 210 447 A1 ist ein Verfahren zur Bestimmung des Widerstands von Wicklungen eines Elektromotors bekannt.

Aus der DE 10 2013 012 163 A1 ist eine Prüfvorrichtung zum Prüfen von Hochvolt-Komponenten eines Fahrzeugs bekannt.

**Aus der** DE 10 2016 222015 A1 **ist als nächstliegender Stand der Technik ein elektrischer Antrieb bekannt.**

**Aus der** DE 10 2019 008365 A1 **ist ein Verfahren zum Überwachen eines Antriebssystems bekannt.**

Der Erfindung liegt daher die Aufgabe zugrunde, eine Qualitätsprüfung eines Elektromotors effizient, insbesondere kostengünstig und mit möglichst geringem Aufwand, auszuführen. Erfindungsgemäß wird die Aufgabe bei dem Verfahren nach den in Anspruch 5 und bei der Prüfanordnung nach den in Anspruch 1 angegebenen Merkmalen gelöst.

Wichtige Merkmale der Erfindung bei dem Verfahren sind, dass das Verfahren zur Prüfung eines Drehstrommotors vorgesehen ist,
wobei der Stator des Motors drei Anschlüsse für Motorphasen (U, V, W) aufweist,
wobei in einem ersten Verfahrensschritt ein zu einer einphasigen Speisung des Motors zugeordneter Strom-Sollwert bestimmt wird, insbesondere aus den für den dreiphasigen Betrieb des Motors vorgesehenen Nennwerten, insbesondere Nennwert des Motorstroms, bestimmt wird, insbesondere rechnerisch bestimmt wird,
wobei ein zu dem Strom-Sollwert gehörender Spannungsbetrag einer einphasigen Spannung, die zu einer einphasigen Speisung des Motors vorgesehen ist, bestimmt wird, insbesondere rechnerisch bestimmt wird,
in einem zweiten, dem ersten Verfahrensschritt zeitlich nachfolgenden Verfahrensschritt an zwei der Anschlüsse (U, V) eine einphasige Spannung angelegt und der dritte Anschluss (W) nicht versorgt wird, insbesondere also offenbleibt,
wobei der Istwert des dem Motor zugeführten, insbesondere von der Spannung getriebenen, Stroms erfasst wird,
wobei der Istwert der Spannung erfasst wird,
wobei die Spannung derart gestellt wird, dass der Istwert des Stroms auf den Strom-Sollwert hin geregelt wird und/oder dass die Regelabweichung, also die Differenz zwischen Istwert des Stroms und Strom-Sollwert, auf Null hin geregelt wird,
wobei, wenn die Regelabweichung betragsmäßig einen Schwellwert unterschreitet,
das Ergebnis der Prüfung des Motors davon abhängt, ob der, insbesondere dann, erreichte Istwert der Spannung ein unzulässig hohes Maß an Abweichung von dem Spannungsbetrag aufweist oder nicht.

Von Vorteil ist dabei, dass durch die einphasige Spannung, also das Versorgen von nur zwei statt drei Motorphasen, eine mechanische Blockierung nicht notwendig ist. Der Aufwand, insbesondere Arbeitsaufwand und Kostenaufwand, zur Herstellung einer mechanischen Blockierung entfällt. Es muss also nur an zwei Anschlüssen des Motors eine Kontaktierung vorgenommen werden. Auf diese Weise ist eine schnelle und einfache Prüfung ermöglicht.

Bei der Prüfung wird vom Regler der dem Motor zugeführte Strom auf einen zuvor berechneten Stromsollwert hingeregelt, wobei der zugehörige Spannungswert auf eine unzulässig große Abweichung von einem vorher berechneten Wert überwacht wird und das Ergebnis der Überwachung das Ergebnis der Prüfung ist oder bestimmt.

Zur Berechnung des zum einphasigen Versorgen zugehörigen Stromsollwerts und des zugehörigen Spannungswertes wird die Belastung der jeweiligen Motorphasenwicklung mit der einphasigen Versorgung der im dreiphasigen Nennbetrieb vorhandenen Belastung angeglichen. Somit ist die Belastung der jeweiligen Motorphasenwicklung dieselbe. Allerdings wird keine Drehmagnetfeld erzeugt und somit auch keine Drehbewegung des Rotors bewirkt, insbesondere so dass keine mechanische Blockierung notwendig ist. Eine Drehbewegung muss vorzugsweise vermieden werden, damit ein möglichst starker Strom im Kurzschlusskäfig induziert wird.

Bei einer vorteilhaften Ausgestaltung wird das Ergebnis der Prüfung akustisch und/oder optisch angezeigt und/oder an einen Rechner übermittelt. Von Vorteil ist dabei, dass eine schnelle und einfache Prüfung ausführbar ist.

Bei einer vorteilhaften Ausgestaltung wird, wenn die Regelabweichung betragsmäßig einen Schwellwert unterschreitet und wenn der, insbesondere dann erreichte, Istwert der Spannung kein unzulässig hohes Maß an Abweichung von dem Spannungsbetrag aufweist, das Ergebnis der Prüfung des Motors als positiv angezeigt, übermittelt und/oder weitergeleitet. Von Vorteil ist dabei, dass bei Erreichen der zuvor bestimmten Werte, insbesondere des Stroms und der Spannung, die Prüfung als bestanden bewertbar ist und ansonsten als nicht bestanden. Dabei wird die Spannung immer weiter erhöht, bis der Strom den Strom-Sollwert im Wesentlichen, also im Rahmen einer zulässigen Abweichung, erreicht hat und dann wird die dazu vorliegende Spannung erfasst. Die in diesem Zustand vorliegende Belastung des Motors gleicht derjenigen Belastung, welche bei einer Prüfung mit dreiphasiger Versorgung und mechanischer Blockierung des Motors erforderlich ist. Vorteil ist bei der Erfindung, dass nur eine einphasige Spannung vorhanden sein muss und trotzdem die Prüfbedingung, welche eigentlich für den dreiphasigen Betrieb vorgesehen ist, ausführbar ist.

Bei einer vorteilhaften Ausgestaltung wird, wenn die Regelabweichung betragsmäßig einen Schwellwert unterschreitet und wenn der, insbesondere dann erreichte, Istwert der Spannung ein unzulässig hohes Maß an Abweichung von dem Spannungsbetrag aufweist, das Ergebnis der Prüfung des Motors als negativ angezeigt, übermittelt und/oder weitergeleitet. Von Vorteil ist dabei, dass bei Erreichen der zuvor bestimmten Werte, insbesondere des Stroms und der Spannung, die Prüfung als bestanden bewertbar ist und ansonsten als nicht bestanden. Dabei wird die Spannung immer weiter erhöht, bis der Strom den Strom-Sollwert im Wesentlichen, also im Rahmen einer zulässigen Abweichung, erreicht hat und dann wird die dazu vorliegende Spannung erfasst. Die in diesem Zustand vorliegende Belastung des Motors gleicht derjenigen Belastung, welche bei einer Prüfung mit dreiphasiger Versorgung und mechanischer Blockierung des Motors erforderlich ist. Vorteil ist bei der Erfindung, dass nur eine einphasige Spannung vorhanden sein muss und trotzdem die Prüfbedingung, welche eigentlich für den dreiphasigen Betrieb vorgesehen ist, ausführbar ist.

Bei einer vorteilhaften Ausgestaltung weist der Motor einen relativ zum Stator drehbar gelagerten Rotor aufweist, der einen Kurzschlusskäfig auf,
insbesondere wobei der Motor als Asynchronmotor ausgeführt ist. Von Vorteil ist dabei, dass durch Bestromung des Stators eine Spannung im Kurzschlusskäfig induzierbar ist, welche einen hohen Strom im Kurzschlusskäfig treibt.

Bei einer vorteilhaften Ausgestaltung ist der Rotor des Motors mechanisch frei drehbar gelagert ist, insbesondere wird also nicht mechanisch blockiert. Von Vorteil ist dabei, dass die Prüfung mit nur geringem Aufwand durchführbar ist.

Wichtige Merkmale bei der Prüfanordnung für einen Drehstrommotor, insbesondere zur Durchführung eines vorgenannten Verfahrens, sind, dass die Prüfanordnung eine steuerbare Spannungsquelle aufweist, die ausgangsseitig dem Motor eine einphasige Spannung an zwei seiner drei Motorphasen zur Verfügung stellt,
wobei ein Regler der Prüfanordnung die Spannungsquelle derart steuert, dass der Istwert des von der einphasigen Spannung dem Motor zugeführten Stroms auf einen Strom-Sollwert hin geregelt wird,
wobei ein Vergleichsmittel der Prüfanordnung eingerichtet ist, einen Schwellwert mit dem Betrag der Differenz zwischen dem Istwert des von der einphasigen Spannung dem Motor zugeführten Stroms und dem Strom-Sollwert zu vergleichen,
wobei das Vergleichsmittel mit einem Überwachungsmittel der Prüfanordnung derart verbunden ist, dass nach betragsmäßiger Unterschreitung eines Schwellwerts durch die Regelabweichung, also durch die Differenz zwischen dem Istwert des von der einphasigen Spannung dem Motor zugeführten Stroms und dem Strom-Sollwert, der Wert der von der Spannungsquelle bereit gestellten Spannung dem Überwachungsmittel zugeführt wird,
wobei das Überwachungsmittel eingerichtet ist, den Wert auf ein unzulässig hohes Maß an Abweichung von einem Spannungswert zu überwachen und das Ergebnis der Überwachung anzuzeigen und/oder weiterzuleiten.

Von Vorteil ist dabei, dass die Prüfung einfach, schnell und effizient durchführbar ist. Insbesondere ist keine mechanische Blockierung des Rotors notwendig.

Bei einer vorteilhaften Ausgestaltung wird ist der Regler ein linearer Regler, insbesondere PI-Regler. Von Vorteil ist dabei, dass der Regler einfach und kostengünstig herstellbar ist.

Bei einer vorteilhaften Ausgestaltung weist der Rotor des Motors einen Kurzschlusskäfig auf. Von Vorteil ist dabei, dass der Kurzschlusskäfig durch Bestromung des Stators prüfbar ist.

Bei einer vorteilhaften Ausgestaltung weist die Prüfanlage einen Rechner auf, der mit dem Vergleichsmittel und dem Überwachungsmittel sowie dem Regler verbunden oder integriert ausgebildet ist. Von Vorteil ist dabei, dass eine einfache und schnelle Durchführung der Prüfung ausführbar ist.

Weitere Vorteile ergeben sich aus den Unteransprüchen.

Die Erfindung wird nun anhand von schematischen Abbildungen näher erläutert:

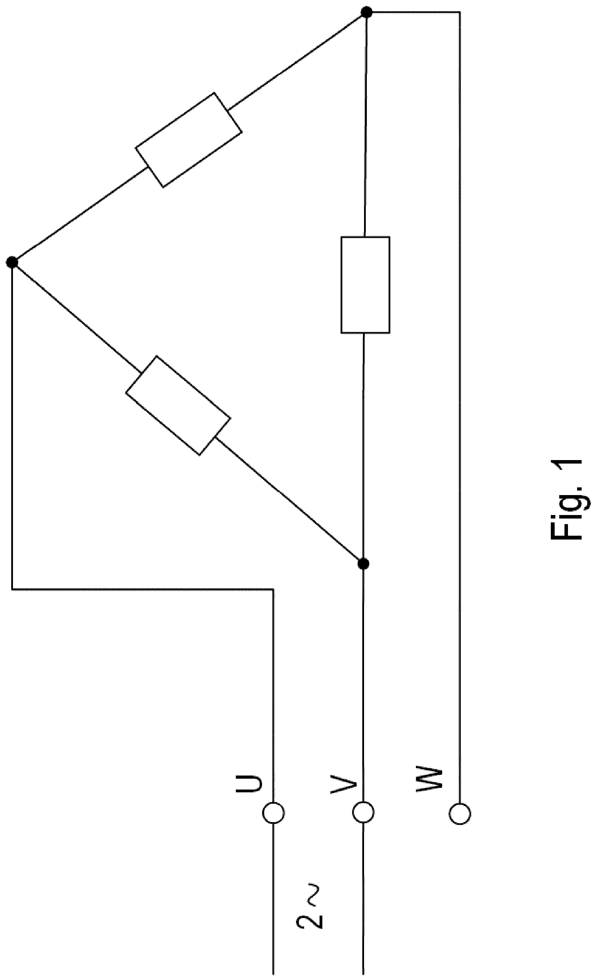

In der Figur 1 ist eine zweiphasige Bestromung eines Stators einer dreiphasig betreibbaren Drehstrommotors schematisch dargestellt.

Wie in Figur 1 gezeigt, weist der Stator eines Drehstrommotors drei Wicklungen auf, die in Dreieckschaltung miteinander verschaltet sind.

Der Rotor des Motors weist einen Kurzschlusskäfig auf. Vorzugsweise ist der Motor als Asynchronmotor ausgeführt.

Nach Herstellung des Motors wird zur Sicherung der Fertigungsqualität eine Prüfung des Motors durchgeführt.

Hierzu wäre nach Stand der Technik der Rotor mechanisch zu blockieren und dann der Stator aus einer Drehspannungsquelle mit einem Drehstrom zu beaufschlagen, wobei die Drehspannung und der Drehstrom erfasst werden und daraus die vom Motor aufgenommene Leistung bestimmt wird. Eine Überwachungsvorrichtung überwacht, ob die so bestimmte Leistung in einem Sollbereich liegt, insbesondere also ob ein unzulässig hohes Maß an Abweichung von einem Leistungs-Sollwert erreicht ist.

Erfindungsgemäß ist aber die mechanische Blockierung nicht notwendig, da nur eine einphasige Spannung dem Stator an den beiden Anschlüssen für die Motorphasen U und V zur Verfügung gestellt wird, so dass also eine Motorphase W von den drei Motorphasen (U, V, W) nicht versorgt ist. Eine Drehbewegung des Rotors ist somit auch ohne mechanische Blockierung verhindert, da der Stator dem Rotor kein Drehfeld zur Verfügung stellt.

Insbesondere ist der Rotor also während der Prüfung frei drehbar angeordnet, dreht aber nicht.

Die bei dem erfindungsgemäß einphasigen Versorgen des Drehstrommotors an den Motorphasenanschlüssen (U, V, W) anliegenden Phasenspannungen werden erfasst und ebenso die Phasenströme. Die einphasige Spannung wird auf einen derartigen Wert gesteuert, dass der Strom einen Sollwert erreicht, welcher zuvor berechnet wurde und der Prüfbedingung entspricht. Die zum Erreichen des Stromsollwerts benötigte Spannung wird auf ein unzulässig hohes Maß an Abweichung von einem Spannungssollwert überwacht. Somit ist eine schnelle und wenig einfache Prüfung des Motors ermöglicht.

Die Offenbarung umfasst also folgende Verfahrensschritte:
Für die einphasige Versorgung des Drehstrommotors wird ein Strom-**Sollwert** bestimmt, insbesondere berechnet, wobei dieser Strom-Sollwert aus dem dreiphasigen Nennstromwert des Motors bestimmt wird und für die einphasige Bestromung dann relevant ist. Auch der Betrag der zum Strom-Sollwert zugehörigen einphasigen Versorgungsspannung wird bestimmt.

Danach werden nur 2 Motorphasen mit zwei Phasen einer Drehspannungsquelle bestromt oder mit einer einphasigen Spannungsquelle gespeist, so dass die einphasige Versorgungsspannung steuerbar ist.

Der Strom dem Motor aus der einphasigen Spannungsquelle zugeführte Strom wird erfasst. Nun wird die Spannung dann auf einen derartigen Wert gebracht, dass der Strom **den Strom-Sollwert** erreicht.

Der so erreichte Spannungswert wird auf ein unzulässig hohes Maß an Abweichung von dem anfangs bestimmten Betrag überwacht und das Ergebnis dieser Überwachung als Ergebnis der Prüfung angezeigt.

Im Ergebnis ist dann der Kurzschlusskäfig des Rotors des Asynchronmotors auf Produktionsfehler geprüft, obwohl nur der Stator bestromt wurde und der Rotor nicht blockiert wurde. Insbesondere entfällt ein A-seitiges oder B-seitiges Halten.

Insbesondere wird ein Regler vorgesehen, welchem der erfasste Wert des Stroms zugeführt wird und welcher die Spannung derart stellt, dass der erfasste Wert des Stroms auf den Sollwert hingeregelt wird. Die Regeldifferenz, also die Differenz zwischen dem erfassten Wert des Stroms und Sollwert wird außerdem einem Vergleichsmittel zugeführt, welches bei betragsmäßigem Unterschreiten eines Schwellwerts ein Abspeichern des aktuell erreichten, insbesondere gestellten, Wertes der Spannung in einen Speicher auslöst und/oder den aktuell erreichten, insbesondere gestellten, Wertes der Spannung einem Überwachungsmittel freigibt, das den Wert auf ein unzulässig hohes Maß an Abweichung von dem anfangs bestimmten Betrag überwacht und das Ergebnis dieser Überwachung als Ergebnis der Prüfung angezeigt.

Insbesondere ist der Nennwert des Motorstroms derjenige Strombetrag, bei dessen dauerhafter Überschreitung der Motor beziehungsweise der Stator des Motors technisch versagt, insbesondere also mit hoher Wahrscheinlichkeit durch Überlastung zerstört wird.

Bei weiteren erfindungsgemäßen Ausführungsbeispielen wird der Stator statt mit der Dreieckschaltung mit einer Sternschaltung ausgeführt.

### Bezugszeichenliste

2~ einphasige Versorgungsspannung
U Motorphase
V Motorphase
W Motorphase

## Patentansprüche

1. Prüfanordnung für einen Drehstrommotor,
**wobei** die Prüfanordnung eine steuerbare Spannungsquelle aufweist, die ausgangsseitig dem Motor eine einphasige Spannung an zwei seiner drei Motorphasen (U, V, W) zur Verfügung stellt,
wobei ein Regler der Prüfanordnung die Spannungsquelle derart steuert, dass der Istwert des von der einphasigen Spannung dem Motor zugeführten Stroms auf einen Strom-Sollwert hin geregelt wird,
**dadurch gekennzeichnet, dass**
ein Vergleichsmittel der Prüfanordnung eingerichtet ist, einen Schwellwert mit dem Betrag der Differenz zwischen dem Istwert des von der einphasigen Spannung dem Motor zugeführten Stroms und dem Strom-Sollwert zu vergleichen,
wobei das Vergleichsmittel mit einem Überwachungsmittel der Prüfanordnung derart verbunden ist, dass nach betragsmäßiger Unterschreitung eines Schwellwerts durch die Regelabweichung, also durch die Differenz zwischen dem Istwert des von der einphasigen Spannung dem Motor zugeführten Stroms und dem Strom-Sollwert, der Wert der von der Spannungsquelle bereit gestellten Spannung dem Überwachungsmittel zugeführt wird,
wobei das Überwachungsmittel eingerichtet ist, den Wert auf ein unzulässig hohes Maß an Abweichung von einem Spannungswert zu überwachen und das Ergebnis der Überwachung anzuzeigen und/oder weiterzuleiten.

2. Prüfanordnung nach Anspruch 1,
**dadurch gekennzeichnet, dass**
der Regler ein linearer Regler, insbesondere PI-Regler, ist.

3. Prüfanordnung nach einem der vorangegangenen Ansprüche,
**dadurch gekennzeichnet, dass**
der Rotor des Motors einen Kurzschlusskäfig aufweist.

4. Prüfanordnung nach einem der vorangegangenen Ansprüche,
**dadurch gekennzeichnet, dass**
die Prüfa**nordnung** einen Rechner aufweist, der mit dem Vergleichsmittel und dem Überwachungsmittel sowie dem Regler verbunden oder integriert ausgebildet ist.

5. Verfahren zur Prüfung eines Drehstrommotors **mit einer Prüfanordnung nach einem der vorangegangenen Ansprüche,**
wobei der Stator des Motors drei Anschlüsse für Motorphasen (U, V, W) aufweist,
wobei
**in einem ersten Verfahrensschritt** ein zu einer einphasigen Speisung des Motors zugeordneter **Strom-Sollwert** bestimmt wird, insbesondere aus den für den dreiphasigen Betrieb des Motors vorgesehenen Nennwerten, insbesondere Nennwert des Motorstroms, bestimmt wird, insbesondere rechnerisch bestimmt wird,
wobei ein zu dem Strom-Sollwert gehörender **Spannungsbetrag** einer einphasigen Spannung, die zu einer einphasigen Speisung des Motors vorgesehen ist, bestimmt wird, insbesondere rechnerisch bestimmt wird,
**in einem zweiten, dem ersten Verfahrensschritt zeitlich nachfolgenden Verfahrensschritt** an zwei der Anschlüsse (U, V) eine einphasige Spannung angelegt und der dritte Anschluss (W) nicht versorgt wird, insbesondere also offenbleibt,
wobei der Istwert des dem Motor zugeführten, insbesondere von der Spannung getriebenen, Stroms erfasst wird,
wobei der Istwert der Spannung erfasst wird,
wobei die Spannung derart gestellt wird, dass der Istwert des Stroms auf den Strom-Sollwert hin geregelt wird und/oder dass die Regelabweichung, also die Differenz zwischen Istwert des Stroms und Strom-Sollwert, auf Null hin geregelt wird,
wobei, wenn die Regelabweichung betragsmäßig einen Schwellwert unterschreitet,
das Ergebnis der Prüfung des Motors davon abhängt, ob der, insbesondere dann erreichte, Istwert der Spannung ein unzulässig hohes Maß an Abweichung von dem Spannungsbetrag aufweist oder nicht,
**insbesondere wobei der Nennwert des Motorstroms derjenige Strombetrag ist, bei dessen dauerhafter Überschreitung der Motor beziehungsweise der Stator des Motors technisch versagt, insbesondere also mit hoher Wahrscheinlichkeit durch Überlastung zerstört wird.**

6. Verfahren nach Anspruch 5,
**dadurch gekennzeichnet, dass**
das Ergebnis der Prüfung akustisch und/oder optisch angezeigt wird und/oder übermittelt wird an einen Rechner.

7. Verfahren nach Anspruch 5 oder 6,
**dadurch gekennzeichnet, dass**,
wenn die Regelabweichung betragsmäßig einen Schwellwert unterschreitet und wenn der, insbesondere dann erreichte, Istwert der Spannung kein unzulässig hohes Maß an Abweichung von dem Spannungsbetrag aufweist,
das Ergebnis der Prüfung des Motors als positiv angezeigt, übermittelt und/oder weitergeleitet wird.

8. Verfahren nach einem der Ansprüche 5 bis 7,
**dadurch gekennzeichnet, dass**,
wenn die Regelabweichung betragsmäßig einen Schwellwert unterschreitet und wenn der, insbesondere dann erreichte, Istwert der Spannung ein unzulässig hohes Maß an Abweichung von dem Spannungsbetrag aufweist,
das Ergebnis der Prüfung des Motors als negativ angezeigt, übermittelt und/oder weitergeleitet wird.

9. Verfahren nach einem der Ansprüche 5 bis 8,
**dadurch gekennzeichnet, dass**
der Motor **einen** relativ zum Stator drehbar gelagerten Rotor aufweist, der einen Kurzschlusskäfig aufweist,
insbesondere wobei der Motor als Asynchronmotor ausgeführt ist.

10. Verfahren nach einem der Ansprüche 5 bis 9,
**dadurch gekennzeichnet, dass**
der Rotor des Motors mechanisch frei drehbar gelagert ist, insbesondere also nicht mechanisch blockiert wird.

## Claims

1. Testing arrangement for a three-phase motor, the testing arrangement having a controllable voltage source which, at its output, provides the motor with a single-phase voltage at two of its three motor phases (U, V, W),
a controller of the testing arrangement controlling the voltage source such that the actual value of the current fed to the motor by the single-phase voltage is controlled towards a current setpoint,
**characterised in that**
a comparison means of the testing arrangement is configured to compare a threshold value with the absolute value of the difference between the actual value of the current fed to the motor by the single-phase voltage and the current setpoint,
the comparison means being connected to a monitoring means of the testing arrangement in such a way that, once the control error, i.e. the difference between the actual value of the current fed to the motor by the single-phase voltage and the current setpoint, drops below a threshold value in absolute terms, the value of the voltage provided by the voltage source is fed to the monitoring means,
the monitoring means being configured to monitor the value for an impermissibly high level of deviation from a voltage value and to display and/or relay the result of the monitoring.

2. Testing arrangement according to claim 1,
**characterised in that**
the controller is a linear controller, in particular a PI controller.

3. Testing arrangement according to any of the preceding claims,
**characterised in that**
the rotor of the motor has a squirrel cage.

4. Testing arrangement according to any of the preceding claims,
**characterised in that**
the testing arrangement has a computer that is either connected to the comparison means, the monitoring means and the controller or formed so as to be integrated therewith.

5. Method for testing a three-phase motor using a testing arrangement according to any of the preceding claims,
wherein the stator of the motor has three terminals for motor phases (U, V, W),
wherein, in a first method step, a current setpoint assigned to a single-phase feed of the motor is determined, in particular is determined, in particular computed, from the nominal values intended for three-phase operation of the motor, in particular the nominal value of the motor current,
wherein an absolute voltage value, belonging to the current setpoint, of a single-phase voltage intended for a single-phase feed of the motor is determined, in particular computed, in a second method step chronologically following the first method step, a single-phase voltage is applied to two of the terminals (U, V), and no voltage is supplied to the third terminal (W), i.e. in particular the third terminal remains free,
wherein the actual value of the current that is fed to the motor, in particular that is driven by the voltage, is detected,
wherein the actual value of the voltage is detected,
wherein the voltage is set such that the actual value of the current is controlled towards the current setpoint and/or such that the control error, i.e. the difference between the actual value of the current and the current setpoint, is controlled towards zero,
wherein, if the control error drops below a threshold value in absolute terms,
the result of the test on the motor is dependent on whether or not the actual value of the voltage, reached in particular at that point, has an impermissibly high level of deviation from the absolute voltage value,
in particular wherein the nominal value of the motor current is the absolute current value at which the motor or the stator of the motor technically breaks down, i.e. in particular is highly likely to be destroyed due to overloading, if said value is consistently exceeded.

6. Method according to claim 5,
**characterised in that**
the result of the test is displayed acoustically and/or optically and/or is transmitted to a computer.

7. Method according to claim 5 or claim 6,
**characterised in that**,
if the control error drops below a threshold value in absolute terms, and if the actual value of the voltage, reached in particular at that point, does not have an impermissibly high level of deviation from the absolute voltage value, the result of the test on the motor is displayed, transmitted and/or relayed as being positive.

8. Method according to any of claims 5 to 7,
**characterised in that**,
if the control error drops below a threshold value in absolute terms, and if the actual value of the voltage, reached in particular at that point, does have an impermissibly high level of deviation from the absolute voltage value, the result of the test on the motor is displayed, transmitted and/or relayed as being negative.

9. Method according to any of claims 5 to 8,
**characterised in that**
the motor has a rotor which is mounted rotatably relative to the stator and which has a squirrel cage,
the motor in particular being configured as an asynchronous motor.

10. Method according to any of claims 5 to 9,
**characterised in that**
the rotor of the motor is mounted so as to be mechanically freely rotatable, i.e. in particular is not mechanically locked.

## Revendications

1. Dispositif de test pour un moteur triphasé,
le dispositif de test comprenant une source de tension pouvant être commandée et fournissant côté sortie une tension monophasée au moteur au niveau de deux de ses trois phases de moteur (U, V, W),
un régulateur du dispositif de test commandant la source de tension de telle manière que la valeur réelle du courant fourni au moteur par la tension monophasée est régulée en fonction d'une valeur de consigne de courant,
**caractérisé en ce que**
un moyen de comparaison du dispositif de test est conçu pour comparer une valeur de seuil avec le montant de la différence entre la valeur réelle du courant fourni au moteur par la tension monophasée et la valeur de consigne de courant,
le moyen de comparaison étant relié à un moyen de surveillance du dispositif de test de telle manière que, après un dépassement inférieur du montant d'une valeur de seuil par l'écart de régulation, c'est-à-dire par la différence entre la valeur réelle du courant fourni au moteur par la tension monophasée et la valeur de consigne de courant, la valeur de la tension déjà fournie par la source de tension est envoyée au moyen de surveillance,
le moyen de surveillance étant conçu pour surveiller la valeur relativement à un degré d'écart inacceptablement élevé par rapport à une valeur de tension et pour afficher et/ou transmettre le résultat de la surveillance.

2. Dispositif de test selon la revendication 1,
**caractérisé en ce que**
le régulateur est un régulateur linéaire, en particulier un régulateur PI.

3. Dispositif de test selon l'une quelconque des revendications précédentes,
**caractérisé en ce que**
le rotor du moteur présente une cage de court-circuit.

4. Dispositif de test selon l'une quelconque des revendications précédentes,
**caractérisé en ce que**
le dispositif de test présente un calculateur qui est relié au moyen de comparaison et au moyen de surveillance ainsi qu'au régulateur ou est réalisé de manière intégrée.

5. Procédé de test d'un moteur triphasé comprenant un dispositif de test selon l'une quelconque des revendications précédentes,
le stator du moteur présentant trois bornes pour les phases de moteur (U, V, W),
une valeur de consigne de courant associée à une alimentation monophasée du moteur étant déterminée dans une première étape de procédé, en particulier à partir des valeurs nominales prévues pour le fonctionnement triphasé du moteur, une valeur nominale du courant de moteur étant en particulier déterminée, en particulier étant déterminée par calcul,
une quantité de tension, appartenant à la valeur de consigne de courant, d'une tension monophasée prévue pour une alimentation monophasée du moteur étant déterminée, en particulier étant déterminée par calcul, une tension monophasée étant appliquée à deux des bornes (U, V) dans une deuxième étape de procédé succédant chronologiquement à la première étape de procédé, et la troisième borne (W) n'est pas alimentée et restant donc en particulier ouverte,
la valeur réelle du courant fourni au moteur, en particulier induit par la tension, étant détectée,
la valeur réelle de la tension étant détectée,
la tension étant ajustée de telle manière que la valeur réelle du courant est régulée en fonction de la valeur de consigne de courant et/ou que l'écart de régulation, c'est-à-dire la différence entre la valeur réelle du courant et la valeur de consigne de courant, est régulé à zéro,
le résultat du test du moteur dépendant du fait que la valeur réelle de la tension, en particulier alors atteinte, présente ou non un degré d'écart inacceptablement élevé de la quantité de tension lorsque le montant de l'écart de régulation correspond à un dépassement inférieur de la valeur de seuil,
la valeur nominale du courant de moteur étant en particulier la quantité de courant pour lequel un dépassement inférieur permanent entraîne une défaillance technique du moteur ou du stator du moteur, en particulier sa destruction par surcharge avec une forte probabilité.

6. Procédé selon la revendication 5,
**caractérisé en ce que**
le résultat du test est indiqué de manière acoustique et/ou visuelle et/ou est transmis à un calculateur.

7. Procédé selon la revendication 5 ou 6,
**caractérisé en ce que,**
si la quantité de l'écart de régulation est inférieure à une valeur de seuil et si la valeur réelle, en particulier alors atteinte, de la tension ne présente pas un degré d'écart inacceptablement élevé par rapport à la quantité de tension,
le résultat du test du moteur est affiché comme positif, est transmis et/ou est redirigé.

8. Procédé selon l'une quelconque des revendications 5 à 7,
**caractérisé en ce que,**
si le montant de l'écart de régulation est inférieur à une valeur de seuil et si la valeur réelle, en particulier alors atteinte, de la tension présente un degré d'écart inacceptablement élevé par rapport à la quantité de tension,
le résultat du test du moteur est affiché comme négatif, est transmis et/ou est redirigé.

9. Procédé selon l'une quelconque des revendications 5 à 8,
**caractérisé en ce que**
le moteur présente un rotor monté rotatif par rapport au stator et présentant une cage de court-circuit,
le moteur étant en particulier réalisé sous la forme d'un moteur asynchrone.

10. Procédé selon l'une quelconque des revendications 5 à 9,
**caractérisé en ce que**
le rotor du moteur est monté de manière à pouvoir tourner de manière mécaniquement libre, en particulier n'est pas bloqué mécaniquement.
